# EUROPEAN PATENT APPLICATION

(11) **EP 4 542 626 A1**
(43) Date of publication of application: **23.04.2025**
(21) Application number: 23823768.9
(22) Date of filing: 06.06.2023
(51) Int. Cl.: H01L 21/304, H01L 21/56, H01L 23/12

(54) **ADHESIVE COMPOSITION FOR LIGHT IRRADIATION PEELING, LAMINATE, AND METHOD FOR PRODUCING PROCESSED SEMICONDUCTOR SUBSTRATE OR ELECTRONIC DEVICE LAYER**

(30) Priority: 17.06.2022 JP 2022097891
(71) Applicant: Nissan Chemical Corporation, Tokyo 103-6119 (JP)
(72) Inventor: OKUNO, Takahisa, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/020928
(87) International publication number: WO 2023/243475

(57) **Abstract**

Provided are**:** a laminate including an adhesive layer which has an adhesion function and a release function in one layer and can be released by light irradiation, wherein when a semiconductor substrate or an electronic device layer is processed, a support substrate and the semiconductor substrate or the electronic device layer can be firmly adhered to each other, and after the substrate is processed, the support substrate and the semiconductor substrate or the electronic device layer can be easily separated from each other by light irradiation; an adhesive composition with which such a releasable adhesive layer is formed; and a method for producing a processed semiconductor substrate or electronic device layer using such a laminate.

An adhesive composition for release by light irradiation for forming an adhesive layer of a laminate including a semiconductor substrate or an electronic device layer, a support substrate, and the adhesive layer provided between the semiconductor substrate or the electronic device layer and the support substrate, in which the electronic device layer includes a plurality of semiconductor chip substrates and a sealing resin disposed between the semiconductor chip substrates, and the adhesive layer is used to release the semiconductor substrate or the electronic device layer and the support substrate after the adhesive layer absorbs light emitted from the support substrate side, the adhesive composition comprising: a light-absorbing compound that contributes to facilitating release of the semiconductor substrate or the electronic device layer and the support substrate by absorbing the light; an organic resin; and an organic solvent, wherein the light-absorbing compound is a compound having a structure selected from a group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, and a structure derived from cinnamic acid, or a polyphenol-based compound.

## Description

### Technical Field

The present invention relates to an adhesive composition for release by light irradiation, a laminate, and a method for producing a processed semiconductor substrate or electronic device layer.

### Background Art

For a semiconductor wafer that has conventionally been integrated in a two-dimensional planar direction, there is a need for a semiconductor integration technique in which planes are further integrated (laminated) also in a three-dimensional direction for the purpose of further integration. This three-dimensional lamination is a technique for integration in multiple layers while connecting by a through silicon via (TSV). At the time of integration in multiple layers, each wafer to be integrated is thinned by polishing on the opposite side to the formed circuit surface (that is, the back surface), and the thinned semiconductor wafers are laminated.

A pre-thinned semiconductor wafer (also referred to simply as a wafer here) is adhered to a support for polishing with a polishing apparatus. The adhesion at that time need to be easily released after polishing, and therefore is referred to as temporary adhesion. This temporary adhesion needs to be easily removed from the support, and when a large force is applied for the removal, the thinned semiconductor wafer may be cut or deformed, and it is easily removed so that such a thing does not occur. However, at the time of polishing the back surface of the semiconductor wafer, it is not preferable that the semiconductor wafer is detached or displaced due to polishing stress. Therefore, the performance required for temporary adhesion is to withstand the stress during polishing and to be easily removed after polishing.

For example, there is a demand for performance of having a high stress (strong adhesive strength) in the planar direction at the time of polishing and having a low stress (weak adhesive strength) in the longitudinal direction at the time of removal.

Although a method using laser irradiation has been disclosed for such adhesion and separation processes (see, for example, Patent Literatures 1 and 2), a new technique related to release by irradiation with light such as a laser is always required with further progress in the recent semiconductor field.

In addition, in a method for processing a substrate by temporarily adhering a support, examples of the substrate to be temporarily adhered include an electronic device layer including a plurality of semiconductor chip substrates and a sealing resin disposed between the semiconductor chip substrates, in addition to the semiconductor substrate intended for thinning as described above.

A semiconductor package (electronic component) including a semiconductor element (also referred to as a semiconductor chip substrate) has various forms depending on a corresponding size, and examples thereof include a wafer level package (WLP) and a panel level I package (PLP) .

In order to reduce the size of the semiconductor package, it is important to reduce the thickness of the substrate in the element to be incorporated. However, when the thickness of the substrate is reduced, the strength thereof is reduced, and the substrate is more likely to be damaged during production of the semiconductor package. On the other hand, a technique in which a substrate is temporarily adhered to a support using an adhesive, and the substrate is processed, and then the substrate and the support are separated from each other is known (see, for example, Patent Literatures 3 to 5).

### Citation List

### Patent Literature

Patent Literature 1: JP 2004-64040 A
Patent Literature 2: JP 2012-106486 A
Patent Literature 3: JP 2019-34541 A
Patent Literature 4: JP 2020-107649 A
Patent Literature 5: WO 2021/131395 A

### Summary of Invention

### Technical Problem

In order to release a semiconductor substrate corresponding to the semiconductor wafer and a support by laser irradiation, Patent Literatures 1 and 2 describe a laminate in which two layers of a bonding layer (adhesive layer) and a light conversion layer (also referred to as a separation layer) containing a light absorber are laminated between the semiconductor substrate and the support.

Meanwhile, it is desirable from the viewpoint of preparing a laminate having a simpler configuration that a layer having both two functions of the adhesion function of the adhesive layer and the release function that enables release of the substrate and the support of the separation layer can be formed in one layer, because a two-layer configuration of the adhesive layer and the separation layer can be made into one-layer configuration, and the number of layers can be reduced.

Therefore, it is desirable to provide a laminate including an adhesive layer that has both functions of an adhesion function and a release function using light, and can be released by light irradiation, and enables release of a semiconductor substrate and a support.

In addition, in order to release the electronic device layer including a plurality of semiconductor chip substrates disposed in a sealing resin layer and a support by laser irradiation, Patent Literatures 3 and 4 describe a laminate in which two layers of an adhesive layer (adhesive agent layer) and a separation layer are laminated between the electronic device layer and the support.

However, as described above, from the viewpoint of reducing the number of layers and preparing a laminate having a simpler configuration, it is desirable to be able to provide a laminate including a releasable adhesive layer in which a layer having both two functions of an adhesion function of an adhesive layer and a release function of a separation layer is formed in one layer.
Patent Literature 5 describes a laminate including a releasable adhesive layer in which a layer having two functions of an adhesion function of an adhesive layer and a release function of a separation layer is formed in one layer. That is, in order to release the electronic device layer including a plurality of semiconductor chip substrates disposed in a sealing resin layer and a support by laser irradiation, a laminate in which a releasable adhesive layer having both an adhesion function and a release function is formed between an electronic device layer and a support is described.

However, in the adhesive composition for forming an adhesive layer described in Patent Literature 5, a binder resin to be used is limited to a urethane resin type, and Patent Literature 5 only describes an adhesive composition containing the specific binder resin and a general pigment or dye.

In order to make further progress in the recent semiconductor field, a new type of adhesive composition is always required to be developed.

Therefore, the present invention has been made in view of the above circumstances, and an object of the present invention is to provide a laminate including an adhesive layer which has an adhesion function and a release function in one layer and can be released by light irradiation, wherein when a semiconductor substrate or an electronic device layer is processed, a support substrate and the semiconductor substrate or the electronic device layer can be firmly adhered to each other, and after the substrate is processed, the support substrate and the semiconductor substrate or the electronic device layer can be easily separated from each other by light irradiation; an adhesive composition with which such a releasable adhesive layer is formed; and a method for producing a processed semiconductor substrate or electronic device layer using such a laminate.

### Solution to Problem

As a result of intensive studies to solve the above-mentioned problems, the present inventors found that the above-mentioned problems can be solved, and completed the present invention having the following gist.

That is, the present invention includes the following aspects.
[1] An adhesive composition for release by light irradiation for forming an adhesive layer of a laminate including a semiconductor substrate or an electronic device layer, a support substrate, and the adhesive layer provided between the semiconductor substrate or the electronic device layer and the support substrate, in which the electronic device layer includes a plurality of semiconductor chip substrates and a sealing resin disposed between the semiconductor chip substrates, and the adhesive layer is used to release the semiconductor substrate or the electronic device layer and the support substrate after the adhesive layer absorbs light emitted from the support substrate side,
   the adhesive composition containing: a light-absorbing compound that contributes to facilitating release of the semiconductor substrate or the electronic device layer and the support substrate by absorbing the light; an organic resin; and an organic solvent, wherein
   the light-absorbing compound is a compound having a structure selected from a group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, and a structure derived from cinnamic acid, or a polyphenol-based compound.
[2] The adhesive composition according to [1], wherein the light-absorbing compound is a compound having a structure represented by any one of formulae (1) to (8) below. 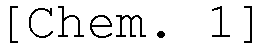 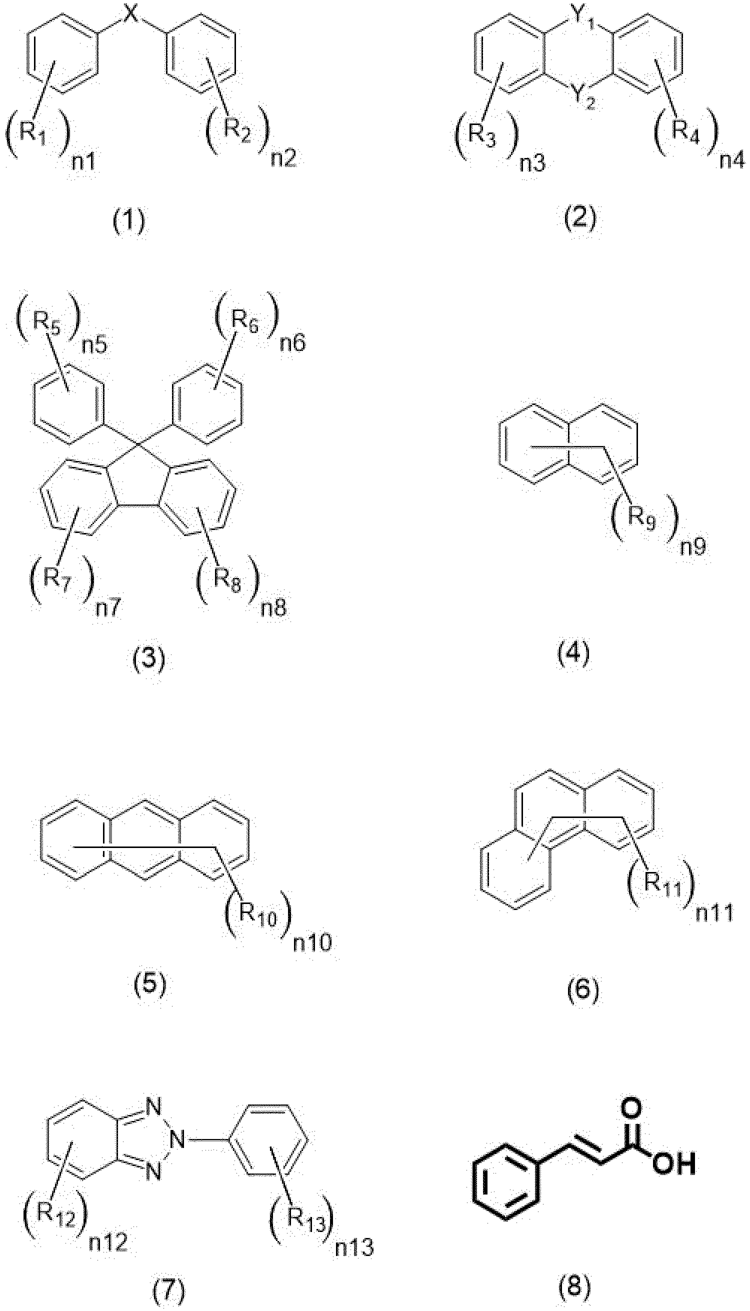
   In the formulae (1) to (8), R₁ to R₁₃ each independently represent a halogen atom or a monovalent group,
   X represents a single bond, -O-, -CO-, -NR₃₁- (R₃₁ represents a hydrogen atom, an alkyl group which may be substituted, or an aryl group which may be substituted), - SO-, -SO₂-, or -N=N-,
   Y₁ represents a single bond or -CO-, when Y₁ is a single bond, Y₂ represents -O-, -CO-, or -NR₃₂- (R₃₂ represents a hydrogen atom, an alkyl group which may be substituted, or an aryl group which may be substituted), when Y₁ is -CO-, Y₂ represents -CO-,
   n1 is an integer of 0 to 4,
   n2 is an integer of 0 to 5,
   n3 is an integer of 0 to 3,
   n4 is an integer of 0 to 4,
   n5 is an integer of 0 to 4,
   n6 is an integer of 0 to 5,
   n7 is an integer of 0 to 4,
   n8 is an integer of 0 to 4,
   n9 is an integer of 0 to 7,
   n10 is an integer of 0 to 9,
   n11 is an integer of 0 to 9,
   n12 is an integer of 0 to 4,
   n13 is an integer of 0 to 4,
   * represents a bond, and
   when there are a plurality of R₁'s to R₁₃'s, each of the plurality of R₁'s to R₁₃'s may be identical or different.
[3] The adhesive composition according to [1], wherein the polyphenol-based compound in the light-absorbing compound is a compound selected from a group consisting of a condensed tannin formed by polymerization of a compound having a flavanol skeleton, a hydrolyzable tannin formed by ester bonding between an aromatic compound of gallic acid or ellagic acid and a sugar, and a flavonoid derived from a compound having a flavanone skeleton structure.
[4] The adhesive composition according to [3], wherein the hydrolyzable tannin is tannic acid represented by formula (9) below. 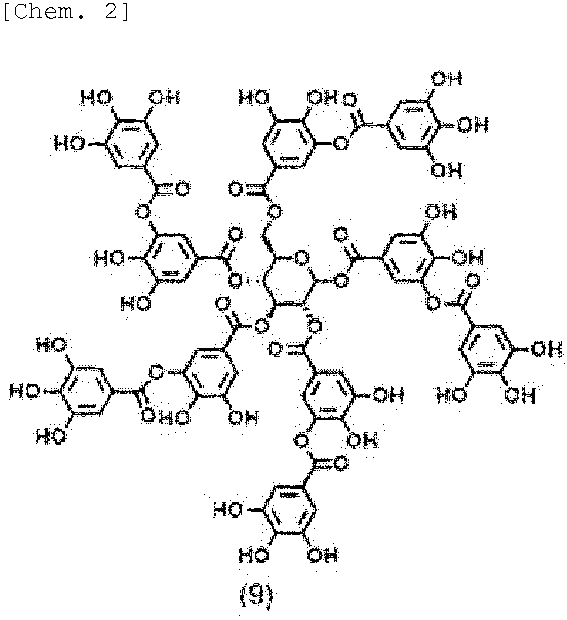
[5] A laminate, including:
   a semiconductor substrate or an electronic device layer;
   a light-transmissive support substrate; and
   an adhesive layer provided between the semiconductor substrate or the electronic device layer and the support substrate, wherein
   the electronic device layer includes a plurality of semiconductor chip substrates and a sealing resin disposed between the semiconductor chip substrates,
   the adhesive layer is used to release the semiconductor substrate or the electronic device layer and the support substrate after the adhesive layer absorbs light emitted from the support substrate side, and
   the adhesive layer is formed from the adhesive composition according to any one of [1] to [4].
[6] A method for producing a processed semiconductor substrate or electronic device layer, the method including:
   a step 5A of processing the semiconductor substrate of the laminate according to [5], or a step 5B of processing the electronic device layer of the laminate according to [5]; and
   a step 6A of separating the semiconductor substrate processed in the step 5A and the support substrate from each other, or a step 6B of separating the electronic device layer processed in the step 5B and the support substrate from each other.
[7] The method for producing a processed semiconductor substrate or electronic device layer according to [6], wherein the step 6A or the step 6B includes a step of irradiating the laminate with a laser from the support substrate side.

### Advantageous Effects of Invention

According to the present invention, it is possible to provide a laminate including an adhesive layer which has an adhesion function and a release function in one layer and can be released by light irradiation, wherein when a semiconductor substrate or an electronic device layer is processed, a support substrate and the semiconductor substrate or the electronic device layer can be firmly adhered to each other, and after the substrate is processed, the support substrate and the semiconductor substrate or the electronic device layer can be easily separated from each other by light irradiation; an adhesive composition with which such a releasable adhesive layer is formed; and a method for producing a processed semiconductor substrate or electronic device layer using such a laminate.

### Brief Description of Drawings

Fig. 1 is a schematic cross-sectional view of an example of a laminate.
Fig. 2 is a schematic cross-sectional view of another example of the laminate.
Fig. 3 is a schematic cross-sectional view for explaining a method for producing the laminate of another example.
Fig. 4 is a schematic cross-sectional view for explaining the method for producing the laminate of another example.
Fig. 5 is a schematic cross-sectional view for explaining the method for producing the laminate of another example.
Fig. 6 is a schematic cross-sectional view for explaining the method for producing the laminate of another example.
Fig. 7 is a schematic cross-sectional view for explaining a method for processing the laminate of another example.
Fig. 8 is a schematic cross-sectional view for explaining the method for processing the laminate of another example.
Fig. 9 is a schematic cross-sectional view for explaining a method for separating the laminate of another example.
Fig. 10 is a schematic cross-sectional view for explaining the method for separating the laminate of another example.
Fig. 11 is a schematic cross-sectional view for explaining a method for cleaning the laminate of another example after separation.

### Description of Embodiments

### (Adhesive composition for release by light irradiation)

The adhesive composition of the present invention is an adhesive composition for release by light irradiation, which enables release by light irradiation.

The adhesive composition of the present invention is a composition that can be suitably used for forming an adhesive layer for temporary adhesion in order to process a semiconductor substrate or an electronic device layer.

The adhesive composition of the present invention contains a light-absorbing compound that contributes to facilitating release of the semiconductor substrate or the electronic device layer and the support substrate by absorbing light, an organic resin, and an organic solvent.

The adhesive composition of the present invention may contain another component in addition to the light-absorbing compound, the organic resin, and the organic solvent.

The adhesive composition of the present invention favorably enables the formation of an adhesive layer for release by light irradiation that effectively functions as both an adhesive layer for temporary adhesion and a laser release agent layer.

### <Light-absorbing compound>

The light-absorbing compound according to the present invention is a compound having a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9-H-fluorene structure, a naphthalene structure, an anthracene structure, a phenanthrene structure, an acridine structure, a pyrene structure, a phenylbenzotriazole structure, and a structure derived from cinnamic acid, or is a polyphenol-based compound.

The light-absorbing compound according to the present invention is preferably one whose absorption spectrum in the range of 250 nm to 800 nm has the highest local maximum absorbance between 250 nm and 350 nm when the absorption spectrum of the light-absorbing compound is measured in the range of 250 nm to 800 nm. The absorption spectrum may have, for example, the highest local maximum between 260 nm and 315 nm. When the light-absorbing compound has such light absorption characteristics, good releasability between the semiconductor substrate or the electronic device layer and the support substrate can be realized.

The absorption spectrum can be measured using a spectrophotometer (for example, an ultraviolet-visible near-infrared (UV-Vis-NIR) spectrophotometer).

The measurement range may be a range equal to or greater than 250 nm to 800 nm as long as the measurement range includes 250 nm to 800 nm.

In the measurement of the absorption spectrum, it is preferable to form a film having such a thickness that the presence of a local maximum can be determined as a measurement sample. For example, the thickness of the film of the measurement sample is about 200 nm.

The light-absorbing compound according to the present invention is preferably a compound having a structure represented by any one of the following formulae (1) to (8).

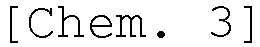

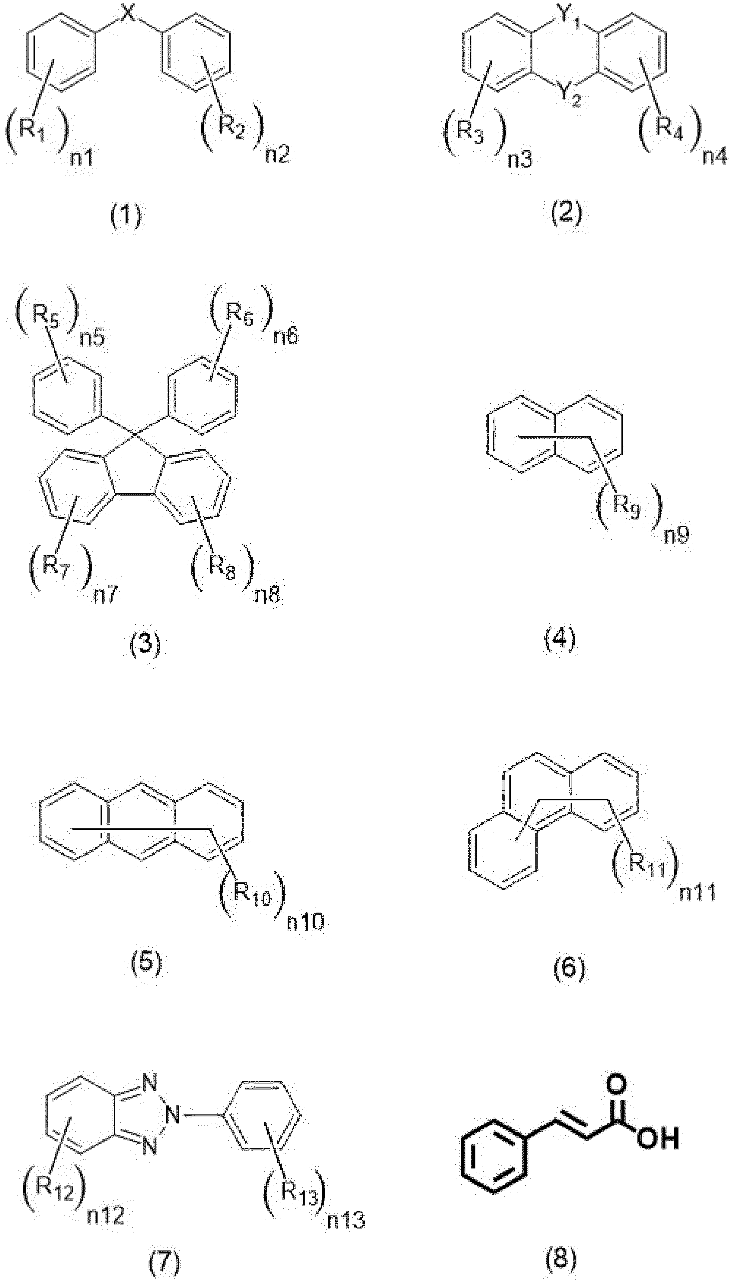

In the formulae (1) to (8), R₁ to R₁₃ each independently represent a halogen atom or a monovalent group,
X represents a single bond, -O-, -CO-, -NR₃₁- (R₃₁ represents a hydrogen atom, an alkyl group which may be substituted, or an aryl group which may be substituted), - SO-, -SO₂-, or -N=N-,
Y₁ represents a single bond or -CO-, when Y₁ is a single bond, Y₂ represents -O-, -CO-, or -NR₃₂- (R₃₂ represents a hydrogen atom, an alkyl group which may be substituted, or an aryl group which may be substituted), when Y₁ is -CO-, Y₂ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,
n13 is an integer of 0 to 4,
* represents a bond, and
when there are a plurality of R₁'s to R₁₃'s, each of the plurality of R₁'s to R₁₃'s may be identical or different.

Examples of the halogen atom in R₁ to R₁₃ include a fluorine atom, a chlorine atom, a bromine atom, and an iodine atom.

Examples of the monovalent group in R₁ to R₁₃ include an atomic group containing two or more atoms, and specific examples thereof include an alkyl group which may be substituted, an alkoxy group which may be substituted, an aryl group which may be substituted, a hydroxy group, a nitro group, a cyano group, a carboxy group, a sulfo group, and -N(R₂₁) (R₂₂) (R₂₁ and R₂₂ each independently represent a hydrogen atom, an alkyl group which may be substituted, or an aryl group which may be substituted).

Examples of the alkyl group which may be substituted in specific examples of R₁ to R₁₃ include an alkyl group which has 1 to 20 carbon atoms and may be substituted. Examples of the substituent include a halogen atom, a hydroxy group, a carboxy group, and an alkoxy group.

Examples of the alkoxy group which may be substituted in specific examples of R₁ to R₁₃ include an alkoxy group which has 1 to 20 carbon atoms and may be substituted. Examples of the substituent include a halogen atom, a hydroxy group, a carboxy group, and an alkyl group.

Examples of the aryl group which may be substituted in specific examples of R₁ to R₁₃ include an aryl group which has 6 to 20 carbon atoms and may be substituted. Examples of the substituent include a halogen atom, a hydroxy group, a carboxy group, an alkyl group, and an alkoxy group.

Specific examples of the alkyl group which may be substituted in R₂₁, R₂₂, R₃₁, and R₃₂ include specific examples of the alkyl group which may be substituted in the specific examples of R₁ to R₁₃.

Specific examples of the aryl group which may be substituted in R₂₁, R₂₂, R₃₁, and R₃₂ include specific examples of the aryl group which may be substituted in the specific examples of R₁ to R₁₃.

Examples of the alkyl group as a substituent include an alkyl group having 1 to 6 carbon atoms.

Examples of the alkoxy group as a substituent include an alkoxy group having 1 to 6 carbon atoms.

The phrase "1 to 20 carbon atoms" in the "alkyl group which has 1 to 20 carbon atoms and may be substituted" represents the number of carbon atoms excluding the number of carbon atoms in the substituent. The same applies to the "aryl group which has 6 to 20 carbon atoms and may be substituted" and the "alkoxy group which has 1 to 20 carbon atoms and may be substituted".

Preferred embodiments of the light-absorbing compound according to the present invention include cinnamic acid, 2-(p-toluoyl)benzoic acid, and 2-naphthyloxyacetic acid.

The polyphenol-based compound in the light-absorbing compound according to the present invention is preferably a compound selected from the group consisting of a condensed tannin formed by polymerization of a compound having a flavanol skeleton, a hydrolyzable tannin formed by ester bonding between an aromatic compound of gallic acid or ellagic acid and a sugar, and a flavonoid derived from a compound having a flavanone skeleton structure.

The polyphenol-based compound according to the present invention represents a plant component having a plurality of phenolic hydroxy groups (hydroxy groups bonded to an aromatic ring such as a benzene ring or a naphthalene ring) in the molecule.

The polyphenol-based compound according to the present invention contains a tannin and a flavonoid.

The tannin according to the present invention refers to a water-soluble compound that is derived from a plant, reacts with and strongly binds to a protein, an alkaloid, or a metal ion to form a poorly soluble salt. Such a tannin is an aromatic compound which is ubiquitous in the plant kingdom and has many phenolic hydroxy groups.

The tannin according to the present invention includes a condensed tannin and a hydrolyzable tannin.

The condensed tannin according to the present invention is a compound obtained by polymerizing a compound having a flavanol skeleton represented by the following formula (p).

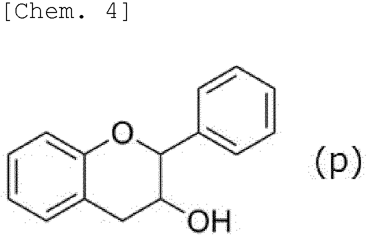

The hydrolyzable tannin according to the present invention is a compound formed by ester bonding between an aromatic compound of gallic acid or ellagic acid represented by the following formula (q) and a sugar such as glucose represented by the following formula (r).

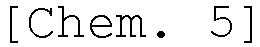

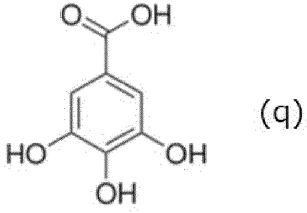

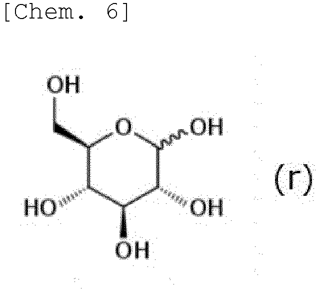

Examples of a preferred embodiment of the hydrolyzable tannin include a tannic acid represented by the following formula (9).

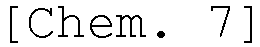

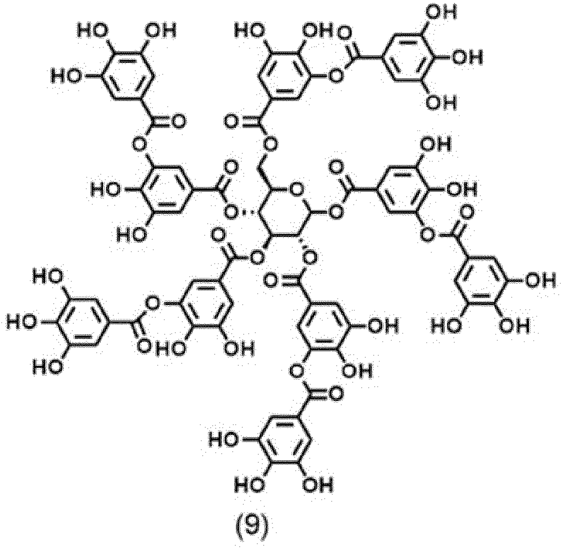

The flavonoid according to the present invention represents a compound biosynthesized by various modifications of a flavanone, which is a kind of flavonoid, and for example, represents a compound derived from a compound having a flavanone skeleton structure represented by the following formula (s).

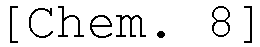

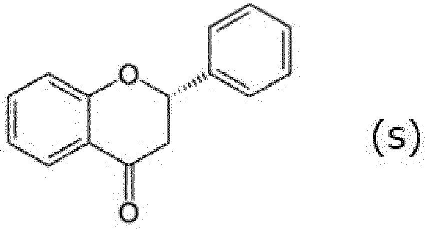

Preferred embodiments of the flavonoid include flavonoids represented by the following formula (10) or formula (11).

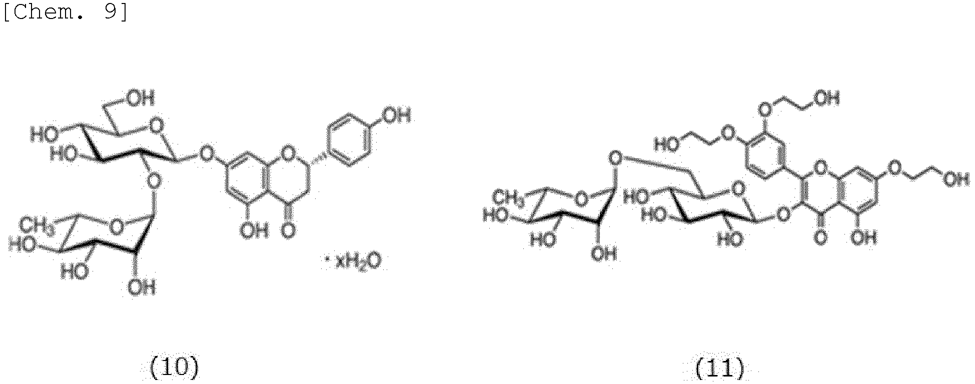

### <Organic resin>

The adhesive composition of the present invention contains a binder component made of an organic resin.

By the incorporation of the binder component, an adhesive layer formed from the adhesive composition of the present invention exhibits excellent stickiness (adhesiveness). Since the adhesive layer of the present invention exhibits excellent stickiness (adhesiveness), the semiconductor substrate or the electronic device layer and the support substrate can be firmly adhered to each other.

As described above, since the adhesive composition of the present invention exhibits excellent stickiness (adhesiveness), it is particularly preferable that the adhesion target is an electronic device layer. When an adhesive layer formed from the adhesive composition of the present invention is used also for the electronic device layer including a plurality of semiconductor chip substrates, each semiconductor chip substrate in the electronic device layer can be firmly adhered to the adhesive layer.

The type of the organic resin is not particularly limited as long as the effect of the present invention is exhibited, and can be appropriately selected according to the purpose, and examples thereof include a poly(meth)acrylic acid-based resin, a novolac resin, a condensed epoxy-based resin, and a polyether-based resin. Among them, from the viewpoint of firmly adhering the semiconductor chip substrate in the electronic device layer, the organic resin is preferably a poly(meth)acrylic acid-based resin.

The "(meth)acrylic acid" refers to methacrylic acid and/or acrylic acid.

Preferred embodiments of the poly(meth)acrylic acid-based resin include a poly(meth)acrylic acid-based resin having a repeating unit represented by the following formula (I).

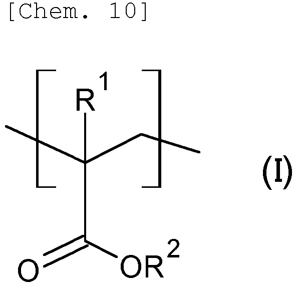

In the formula (I), R₁ represents a hydrogen atom or a methyl group. R² represents a hydrogen atom or a chain saturated hydrocarbon group having 1 to 5 carbon atoms.

Among the poly(meth)acrylic acid-based resins having a repeating unit represented by the above formula (I), preferred embodiments include polyacrylic acid having a repeating unit represented by the following formula (I-1) and polymethyl methacrylate having a repeating unit represented by the following formula (I-2).

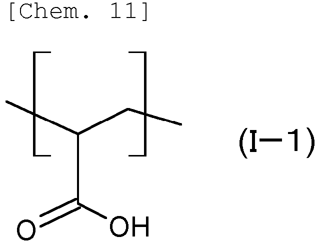

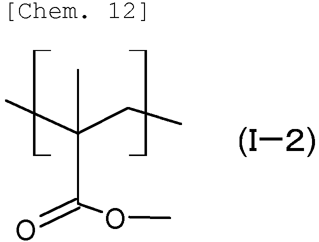

### <Organic solvent>

The adhesive composition of the present invention contains an organic solvent.

Specific examples of the solvent include aliphatic hydrocarbons, aromatic hydrocarbons, and ketones, but are not limited thereto.

More specific examples of the solvent include hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone, but are not limited thereto.

Additional examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether (PGME), propylene glycol monomethyl ether acetate (PGMEA), propylene glycol monoethyl ether, propylene glycol monoethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, and butyl lactate.

As such a solvent, one type can be used alone, or two or more types can be used in combination.

### <<Preparation of adhesive composition>>

The adhesive composition of the present invention can be prepared by mixing the light-absorbing compound, the organic resin, and the organic solvent.

The blending ratio of the light-absorbing compound, the organic resin, and the organic solvent is not particularly limited as long as the effect of the present invention is exhibited, and can be appropriately selected according to the purpose, and for example, the light-absorbing compound : the organic resin : the organic solvent in terms of mass ratio is preferably 1 to 2.5 : 1 to 2.5 : 5 to 8, and more preferably 1 to 1.5 : 1 to 1.5 : 7 to 8.

### (Laminate)

The laminate of the present invention includes a semiconductor substrate or an electronic device layer, a support substrate, and an adhesive layer for release by light irradiation.

The support substrate has light transmittance.

The adhesive layer for release by light irradiation is provided between the semiconductor substrate or the electronic device layer and the support substrate.

The laminate is used for releasing the semiconductor substrate or the electronic device layer and the support substrate after the adhesive layer absorbs light emitted from the support substrate side.

The adhesive layer for release by light irradiation is a layer formed from the adhesive composition for release by light irradiation of the present invention described above.

The laminate of the present invention is used for temporary adhesion in order to process the semiconductor substrate or the electronic device layer, and can be suitably used for processing such as thinning of the semiconductor substrate or the electronic device layer.

While the semiconductor substrate is subjected to processing such as thinning, the semiconductor substrate is supported on the support substrate via the adhesive layer. Meanwhile, after the processing of the semiconductor substrate, the adhesive layer is irradiated with light, and thereafter, the support substrate and the semiconductor substrate are separated from each other.

In addition, while the electronic device layer is subjected to processing such as thinning, the electronic device layer is supported on the support substrate via the adhesive layer. Meanwhile, after the processing of the electronic device layer, the adhesive layer is irradiated with light, and thereafter, the support substrate and the electronic device layer are separated from each other.

With the adhesive layer according to the present invention, the semiconductor substrate or the electronic device layer and the support substrate are easily released after irradiation with light. Furthermore, the residue of the adhesive layer remaining on the semiconductor substrate, the electronic device layer, or the support substrate after the semiconductor substrate or the electronic device layer and the support substrate are released can be removed with, for example, a cleaning agent composition for cleaning the semiconductor substrate or the like.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The dose of light required for release is a dose capable of causing suitable alteration, for example, decomposition of a specific light-absorbing compound.

The light used for release may be laser light or non-laser light emitted from a light source such as an ultraviolet lamp.

Hereinafter, a case where the laminate includes a semiconductor substrate and a case where the laminate includes an electronic device layer will be described in detail separately.

The case where the laminate includes a semiconductor substrate will be described in the following <First embodiment>, and the case where the laminate includes an electronic device layer will be described in the following

### <Second embodiment>.

### <First embodiment>

The laminate having a semiconductor substrate is used for processing a semiconductor substrate. While the semiconductor substrate is subjected to processing, the semiconductor substrate is adhered to the support substrate via the adhesive layer. After the semiconductor substrate is processed, the semiconductor substrate is separated from the support substrate after the adhesive layer is irradiated with light.

### <<Semiconductor substrate>>

The main material forming the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. The shape of the surface of the disk-shaped semiconductor substrate does not need to be a perfect circle, and for example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, but is, for example, 500 to 1,000 µm.

The diameter of the disk-shaped semiconductor substrate may be appropriately determined according to the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) on the opposite side to the surface having the bump is a surface to be subjected to processing.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of about 1 to 200 µm, a bump radius of 1 to 200 µm, and a bump pitch of 1 to 500 µm.

Examples of the material of the bump include a low melting point solder, a high melting point solder, tin, indium, gold, silver, and copper. The bump may be made of only a single component or may be made of a plurality of components. More specific examples thereof include alloy plating mainly containing Sn, such as an SnAg bump, an SnBi bump, an Sn bump, and an AuSn bump.

In addition, the bump may have a laminated structure including a metal layer made of at least one of these components.

An example of the semiconductor substrate is a silicon wafer having a diameter of about 300 mm and a thickness of about 770 µm.

### <<Support substrate>>

The support substrate is not particularly limited as long as it is a member that is transmissive to light emitted on the adhesive layer and can support the semiconductor substrate when the semiconductor substrate is processed, and examples thereof include a support substrate made of glass.

The shape of the support substrate is not particularly limited, and is, for example, a disk shape.

The thickness of the disk-shaped support substrate may be appropriately determined according to the size of the semiconductor substrate and the like, and is not particularly limited, but is, for example, 500 to 1,000 µm.

The diameter of the disk-shaped support substrate may be appropriately determined according to the size of the semiconductor substrate and the like, and is not particularly limited, but is, for example, 100 to 1,000 mm.

An example of the support substrate is a glass wafer having a diameter of about 300 mm and a thickness of about 700 µm.

### <<Adhesive layer>>

The adhesive layer is provided between the support substrate and the semiconductor substrate.

The adhesive layer is, for example, in contact with the semiconductor substrate and in contact with the support substrate.

The adhesive layer is formed using the adhesive composition for release by light irradiation of the present invention described above.

The adhesive composition of the present invention can be suitably used for forming an adhesive layer of a laminate including a semiconductor substrate, a support substrate, and an adhesive layer provided between the semiconductor substrate and the support substrate. The laminate is used for releasing the semiconductor substrate and the support substrate after the adhesive layer absorbs light emitted from the support substrate side.

One of the characteristics of the adhesive layer obtained from the adhesive composition of the present invention is that the semiconductor substrate and the support substrate can be easily released after light irradiation.

The thickness of the adhesive layer is not particularly limited, and is usually 1 to 150 µm, and is preferably 10 µm or more, more preferably 20 µm or more, and still more preferably 30 µm or more from the viewpoint of maintaining the film strength, and is preferably 150 µm or less, more preferably 100 µm or less, still more preferably 80 µm or less, and even more preferably 70 µm or less from the viewpoint of avoiding nonuniformity caused by a thick film.

A method for forming the adhesive layer from the adhesive composition will be described in detail in the explanation section of <<Method for producing laminate of first embodiment>> described below.

Hereinafter, the configuration of the laminate of the first embodiment will be described with reference to the drawings.

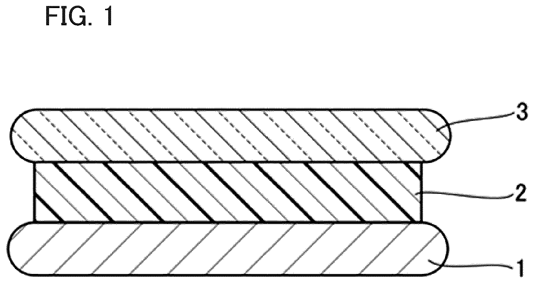

Fig. 1 shows a schematic cross-sectional view of an example of the laminate.

The laminate in Fig. 1 includes a semiconductor substrate 1, an adhesive layer 2, and a support substrate 3 in this order.

The adhesive layer 2 is provided between the semiconductor substrate 1 and the support substrate 3. The adhesive layer 2 is in contact with the semiconductor substrate 1 and the support substrate 3.

### <<Method for producing laminate of first embodiment>>

The laminate of the present invention can be produced, for example, by a method including: a first step of applying an adhesive composition to the surface of either the semiconductor substrate or the support substrate and heating the adhesive composition as necessary to form an adhesive coating layer; and a second step of bonding the semiconductor substrate, the adhesive coating layer, and the support substrate to each other while putting the semiconductor substrate and the support substrate together via the adhesive coating layer and performing at least one of a heating treatment and a decompression treatment.

To explain the second step in more detail, steps of the following embodiment (i) and the following embodiment (ii) are exemplified.
(i) When the adhesive composition is applied to the surface of the semiconductor substrate, the adhesive coating layer of the semiconductor substrate and the support substrate are brought into close contact with each other by applying a load in the thickness direction of the semiconductor substrate and the support substrate while performing at least one of a heating treatment and a decompression treatment, and then a post-heating treatment is performed to obtain a laminate.
(ii) When the adhesive composition is applied to the surface of the support substrate, the adhesive coating layer of the support substrate and the semiconductor substrate are brought into close contact with each other by applying a load in the thickness direction of the semiconductor substrate and the support substrate while performing at least one of a heating treatment and a decompression treatment, and then a post-heating treatment is performed to obtain a laminate.

The application method is not particularly limited, but is usually a spin coating method. A method in which a coating film is separately formed by a spin coating method or the like and a sheet-like coating film is attached as an adhesive coating layer can be adopted.

The heating temperature of the applied adhesive composition varies depending on the type and amount of the component forming the adhesive composition, the boiling point of the solvent used, the desired thickness of the adhesive layer, and the like, and thus cannot be unconditionally defined, but is usually 80 to 200°C, and the heating time is usually 30 seconds to 10 minutes.

Heating can be performed using a hot plate, an oven, or the like.

The film thickness of an adhesive coating layer obtained by applying the adhesive composition and heating the adhesive composition as necessary is usually about 1 to 150 µm, and finally, is appropriately determined so as to fall within the above-mentioned range of the thickness of the adhesive layer.

In the present invention, the laminate of the present invention can be obtained by putting the semiconductor substrate and the support substrate together so as to be in contact with the adhesive layer, bringing the two layers into close contact with each other by applying a load in the thickness direction of the semiconductor substrate and the support substrate while performing either or both of a heating treatment and a decompression treatment, and then performing a post-heating treatment. Which treatment condition, the heating treatment, the decompression treatment, or both in combination, is adopted is appropriately determined in consideration of various circumstances such as the specific formulation of the adhesive composition, the film thickness of the resulting film, and the required adhesive strength.

The heating treatment is appropriately determined in the range of usually 20 to 150°C from the viewpoint of removing the solvent from the composition, softening the adhesive coating layer, and the like. The temperature is preferably 130°C or lower, and more preferably 90°C or lower. The heating time is appropriately determined depending on the heating temperature and the type of adhesive, but is usually 30 seconds or more and preferably 1 minute or more from the viewpoint of reliably exhibiting suitable adhesion, and is usually 10 minutes or less and preferably 5 minutes or less from the viewpoint of preventing alteration of the adhesive layer and other members.

In the decompression treatment, the adhesive coating layer may be exposed to a pressure of 10 to 10,000 Pa. The time for the decompression treatment is usually 1 to 30 minutes.

The load in the thickness direction of the semiconductor substrate and the support substrate is not particularly limited as long as the load does not adversely affect the semiconductor substrate and the support substrate and the two layers therebetween and can firmly bring them into close contact with each other, and is usually within the range of 10 to 1,000 N.

The temperature of the post-heating is preferably 120°C or higher from the viewpoint of achieving a sufficient curing rate and the like, and is preferably 260°C or lower from the viewpoint of preventing alteration of the substrate and each layer and the like.

The post-heating time is usually 1 minute or more, and preferably 5 minutes or more from the viewpoint of realizing suitable bonding of the substrate and the layer forming the laminate, and is usually 180 minutes or less, and preferably 120 minutes or less from the viewpoint of preventing or avoiding an adverse effect of excessive heating on each layer, or the like.

Heating can be performed using a hot plate, an oven, or the like. When the post-heating is performed using a hot plate, heating may be performed with either the semiconductor substrate or the support substrate of the laminate facing downward, but it is preferable to perform the post-heating with the semiconductor substrate facing downward from the viewpoint of realizing suitable release with good reproducibility.

### <Second embodiment>

The laminate having the electronic device layer is used for processing the electronic device layer. While the electronic device layer is processed, the electronic device layer is adhered to the support substrate via the adhesive layer. After the electronic device layer is processed, the electronic device layer is separated from the support substrate after the adhesive layer is irradiated with light.

### <<Electronic device layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member forming at least a part of an electronic component. The electronic device is not particularly limited, and can be one in which various mechanical structures and circuits are formed on the surface of a semiconductor substrate. The electronic device is preferably a complex of a member made of a metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

### <<Support substrate>>

Examples of the support substrate include those similar to those described in the section of <<Support substrate>> of <First embodiment> above.

### <<Adhesive layer>>

The adhesive layer is formed using the adhesive composition for release by light irradiation of the present invention described above.

The detailed description of the adhesive layer is as described in the section of <<Adhesive layer>> of <First embodiment> above.

Hereinafter, the configuration of a second embodiment will be described with reference to the drawings.

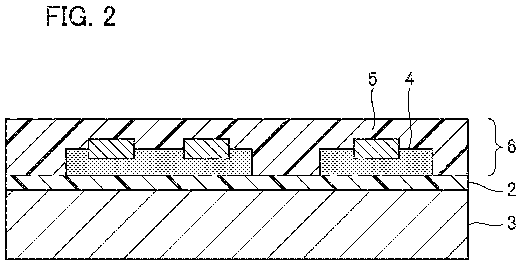

Fig. 2 shows a schematic cross-sectional view of another example of the laminate.

The laminate in Fig. 2 includes a support substrate 3, an adhesive layer 2, and an electronic device layer 6 in this order.

The electronic device layer 6 includes a plurality of semiconductor chip substrates 4 and a sealing resin 5 which is a sealing material disposed between the semiconductor chip substrates 4.

The adhesive layer 2 is provided between the support substrate 3 and the electronic device layer 6. The adhesive layer 2 is in contact with the support substrate 3 and the electronic device layer 6.

### <<Method for producing laminate of second embodiment>>

The laminate of the present invention can be produced, for example, by a method including a first step of applying an adhesive composition to a surface of the support substrate and, if necessary, heating the adhesive composition to form an adhesive coating layer, a second step of placing a semiconductor chip substrate on the adhesive coating layer and bonding the semiconductor chip substrate to the adhesive coating layer while performing at least one of a heating treatment and a decompression treatment, a third step of curing the adhesive coating layer by a post-heating treatment to form an adhesive layer, and a fourth step of sealing the semiconductor chip substrate fixed onto the adhesive layer using a sealing resin.

To explain the second step in more detail, for example, a step of the following embodiment (iii) is exemplified.

(iii) After the adhesive composition is applied to the surface of the support substrate, the semiconductor chip substrate is placed on the adhesive coating layer, and the semiconductor chip substrate and the support substrate are brought into close contact with each other by applying a load in the thickness direction of the semiconductor chip substrate and the support substrate while performing at least one of a heating treatment and a decompression treatment to bond the semiconductor chip substrate to the adhesive coating layer.

The step of forming an adhesive layer by curing the adhesive coating layer through a post-heating treatment defined in the third step may be performed after the semiconductor chip substrate is bonded to the adhesive coating layer in the second step, or may be performed in combination with the second step. For example, by placing the semiconductor chip substrate on the adhesive coating layer and heating and curing the adhesive coating layer while applying a load in the thickness direction of the semiconductor chip substrate and the support substrate, close contact between the semiconductor chip substrate and the adhesive coating layer and curing of the adhesive coating layer to the adhesive layer may be performed together, and the adhesive layer and the semiconductor chip substrate may be bonded together.

The application method, the heating temperature of the applied adhesive composition, the heating means, and the like are as described in <<Method for producing laminate of first embodiment>> of <First embodiment> above.

Hereinafter, the procedure of the method for producing the laminate of the second embodiment will be described in more detail with reference to the drawings.

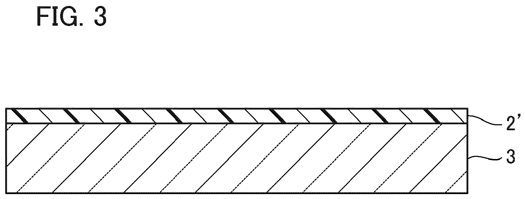

As shown in Fig. 3, an adhesive composition is applied onto the support substrate 3 to form an adhesive coating layer 2'.

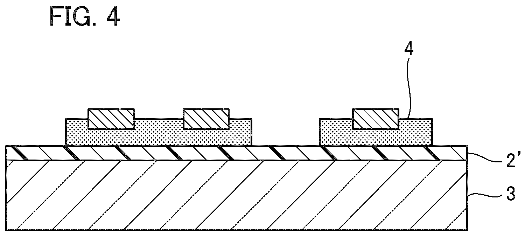

Subsequently, as shown in Fig. 4, the semiconductor chip substrate 4 is placed on the support substrate 3 via the adhesive coating layer 2', and the semiconductor chip substrate 4 and the adhesive coating layer 2' are bonded to each other.

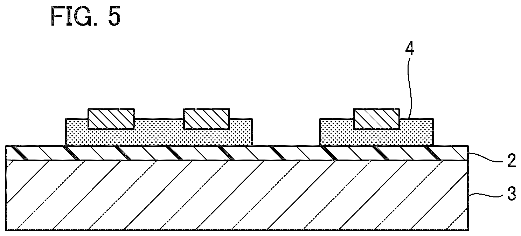

Subsequently, as shown in Fig. 5, the adhesive coating layer 2' is cured to form the adhesive layer 2, and the semiconductor chip substrate 4 is fixed to the adhesive layer 2.

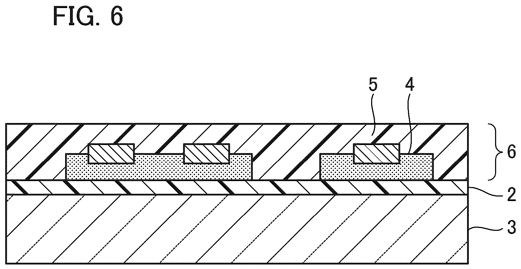

Subsequently, as shown in Fig. 6, the semiconductor chip substrate 4 fixed onto the adhesive layer 2 is sealed using the sealing resin 5. In Fig. 6, the plurality of semiconductor chip substrates 4 temporarily adhered onto the support substrate 3 via the adhesive layer 2 are sealed with the sealing resin 5. The electronic device layer 6 having the semiconductor chip substrates 4 and the sealing resin 5 disposed between the semiconductor chip substrates 4 is formed on the adhesive layer 2, and as described above, the electronic device layer 6 is a base material layer in which a plurality of semiconductor chip substrates are embedded in the sealing resin.

### <<<Sealing step>>>

The semiconductor chip substrate 4 is sealed using a sealing material.

As the sealing material for sealing the semiconductor chip substrate 4, a member capable of insulating or sealing a member made of a metal or a semiconductor is used.

In the present invention, for example, a resin composition is used as the sealing material. The type of the sealing resin is not particularly limited as long as it can seal and/or insulate a metal or a semiconductor, but for example, an epoxy-based resin, a silicone-based resin, or the like is preferably used.

The sealing material may contain other components such as a filler in addition to the resin component. Examples of the filler include spherical silica particles.

In the sealing step, for example, a sealing resin heated to 130 to 170°C is supplied onto the adhesive layer 2 so as to cover the semiconductor chip substrate 4 while maintaining a high viscosity state, and is compression-molded to form a layer including the sealing resin 5 on the adhesive layer 2. At this time, the temperature condition is, for example, 130 to 170°C. The pressure applied to the semiconductor chip substrate 4 is, for example, 50 to 500 N/cm².

### (Method for producing processed semiconductor substrate or electronic device layer)

The present invention also provides a method for producing a processed semiconductor substrate or a method for producing a processed electronic device layer.

In the "method for producing a processed semiconductor substrate", the laminate described in the section of <First embodiment> in (Laminate) above is used. In addition, in the "method for producing a processed electronic device layer", the laminate described in the section of <Second embodiment> in (Laminate) above is used.

A "method for producing a processed semiconductor substrate" will be described in <Third embodiment> below, and a "method for producing a processed electronic device layer" will be described in <Fourth embodiment> below.

### <Third embodiment>

The method for producing a processed semiconductor substrate of the present invention includes the following step 5A and the following step 6A.

Here, the step 5A is a step of processing the semiconductor substrate in the laminate described in the section of <First embodiment> above.

The step 6A is a step of separating the semiconductor substrate processed in the step 5A and the support substrate from each other.

The processing performed on the semiconductor substrate in the step 5A is, for example, processing on the opposite side of the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers, which is three-dimensionally mounted. In addition, for example, a wafer back electrode or the like is also formed before and after that. Heat at about 250 to 350°C is applied in a state of being adhered to the support substrate in wafer thinning and TSV processes. The laminate of the present invention usually has heat resistance to the load including the adhesive layer.

The processing is not limited to the above-described processing, and includes, for example, implementation of a process of mounting a semiconductor component in a case of temporary adhesion to a support substrate in order to support a base material for mounting the semiconductor component.

In the step 6A, examples of a method for separating (releasing) the semiconductor substrate and the support substrate include mechanical release with machinery having a sharp part, and release by pulling apart between a support and a semiconductor wafer after the adhesive layer is irradiated with light, but the method is not limited thereto.

The irradiation of the adhesive layer with light from the support substrate side causes alteration of the adhesive layer (for example, separation or decomposition of the adhesive layer) as described above, and can easily separate the semiconductor substrate and the support substrate by, for example, pulling up one of the substrates thereafter.

The irradiation of the adhesive layer with light does not necessarily have to be performed on the entire region of the adhesive layer. Even if a region irradiated with light and a region not irradiated with light are mixed, the semiconductor substrate and the support substrate can be separated from each other by a slight external force such as pulling up of the support substrate, for example, as long as the releasability is sufficiently improved as the entire adhesive layer. The ratio and positional relationship between the region irradiated with light and the region not irradiated with light vary depending on the type and specific composition of the adhesive to be used, the thickness of the adhesive layer, the thickness of the adhesive layer, the intensity of the light to be emitted, and the like, but those skilled in the art can appropriately set conditions without requiring an excessive test. For such circumstances, according to the method for producing a processed semiconductor substrate of the present invention, for example, in a case where the support substrate of the laminate to be used has light transmittance, it is possible to shorten the light irradiation time when release is performed by light irradiation from the support substrate side, and as a result, not only improvement in throughput can be expected, but also physical stress and the like for release can be avoided, and the semiconductor substrate and the support substrate can be easily and efficiently separated only by light irradiation.

The dose of light required for release is usually 50 to 3,000 mJ/cm². The irradiation time is appropriately determined according to the wavelength and the dose of light.

The wavelength of the light used for release is preferably, for example, a wavelength of 250 to 600 nm, and more preferably a wavelength of 250 to 370 nm as described above. A more suitable wavelength is 308 nm, 343 nm, 355 nm, 365 nm, or 532 nm. The dose of light required for release is a dose capable of causing suitable alteration, for example, decomposition of a specific light-absorbing compound.

The light used for release may be laser light or non-laser light emitted from a light source such as an ultraviolet lamp.

The substrate can be cleaned by spraying a cleaning agent composition onto the surface of at least one of the separated semiconductor substrate and support substrate, or immersing the separated semiconductor substrate or support substrate in a cleaning agent composition.

In addition, the surface of the processed semiconductor substrate or the like may be cleaned using a removal tape or the like.

The constituent elements and methodological elements related to the above-described steps of the method for producing a processed semiconductor substrate of the present invention may be variously changed without departing from the gist of the present invention.

The method for producing a processed semiconductor substrate of the present invention may include steps other than the above-described steps.

In the laminate of the present invention, the semiconductor substrate and the support substrate are temporarily adhered by the adhesive layer in a suitably releasable manner. Therefore, for example, when the support substrate has light transmittance, the semiconductor substrate and the support substrate can be easily separated by irradiating the adhesive layer with light from the support substrate side of the laminate. Usually, release is performed after the semiconductor substrate of the laminate is processed.

### <Fourth embodiment>

The method for producing a processed electronic device layer of the present invention includes the following step 5B and the following step 6B.

Here, the step 5B is a step of processing the electronic device layer in the laminate described in the section of <Second embodiment> above.

The step 6B is a step of separating the electronic device layer processed in the step 5B and the support substrate from each other.

Examples of the processing performed on the electronic device layer in the step 5B include a grinding step and a wiring layer forming step.

### <<Grinding step>>

The grinding step is a step of grinding a resin portion of the layer of the sealing resin 5 in the electronic device layer 6 after the sealing step so that a part of the semiconductor chip substrate 4 is exposed.

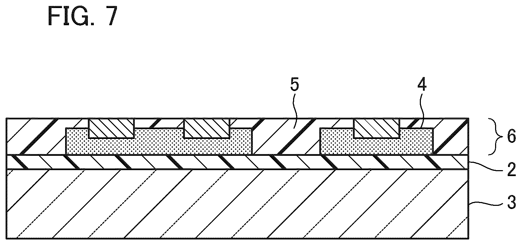

The grinding of the sealing resin portion is performed, for example, by grinding the layer of the sealing resin 5 to a thickness substantially equal to that of the semiconductor chip substrate 4 as shown in Fig. 7.

### <<Wiring layer forming step>>

The wiring layer forming step is a step of forming a wiring layer on the exposed semiconductor chip substrate 4 after the grinding step.

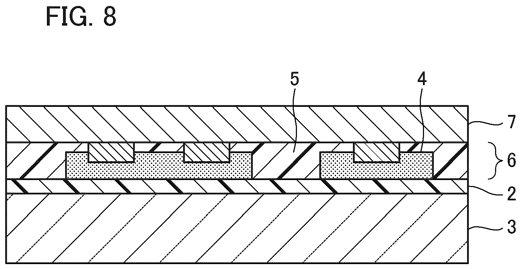

In Fig. 8, a wiring layer 7 is formed on the electronic device layer 6 including the semiconductor chip substrate 4 and the layer of the sealing resin 5.

The wiring layer 7 is also called a redistribution layer (RDL), and is a thin-film wiring body forming wiring connected to a substrate, and may have a single-layer or multi-layer structure. The wiring layer may be one in which wiring is formed by a conductor (for example, a metal such as aluminum, copper, titanium, nickel, gold, or silver, or an alloy such as a silver-tin alloy) between dielectrics (a photosensitive resin such as silicon oxide (SiO_{X}) or photosensitive epoxy), but is not limited thereto.

Examples of a method for forming the wiring layer 7 include the following method.

First, a dielectric layer of silicon oxide (SiO_{X}), a photosensitive resin, or the like is formed on the layer of the sealing resin 5. The dielectric layer made of silicon oxide can be formed by, for example, a sputtering method, a vacuum vapor deposition method, or the like. The dielectric layer made of a photosensitive resin can be formed by applying a photosensitive resin on the layer of the sealing resin 5 by a method such as spin coating, dipping, a roller blade, spray coating, or slit coating.

Subsequently, wiring is formed on the dielectric layer with a conductor such as a metal. As a method for forming the wiring, for example, a known semiconductor process method such as lithography processing such as photolithography (resist lithography) or etching processing can be used. Examples of such lithography processing include lithography processing using a positive resist material and lithography processing using a negative resist material.

In the method for producing a laminate according to the fourth embodiment, further, a bump can be formed on the wiring layer 7 or an element can be mounted. The element can be mounted on the wiring layer 7 using, for example, a chip mounter or the like.

The laminate according to the fourth embodiment may be a laminate prepared in a process based on a fan-out technique in which a terminal provided on a semiconductor chip substrate is mounted on a wiring layer extending outside a chip area.

In the step 6B, examples of a method for separating (releasing) the electronic device layer and the support substrate include mechanical release with machinery having a sharp part, and release by pulling apart between the support and the electronic device layer after the adhesive layer is irradiated with light, but the method is not limited thereto.

The irradiation of the adhesive layer with light from the support substrate side causes alteration of the adhesive layer (for example, separation or decomposition of the adhesive layer) as described above, and can easily separate the electronic device layer and the support substrate by, for example, pulling up one of the substrates thereafter.

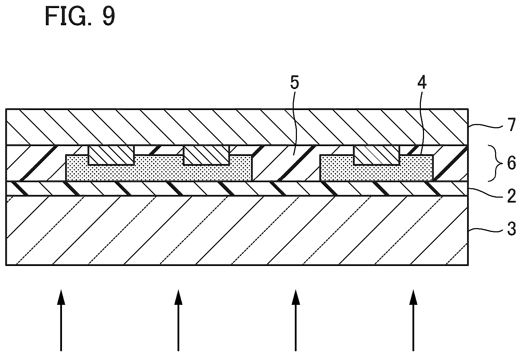

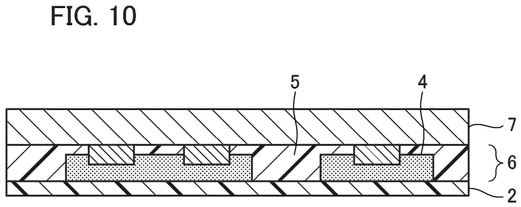

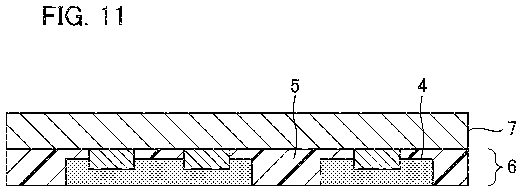

Figs. 9 and 10 are schematic cross-sectional views for explaining a method for separating the laminate, and Fig. 11 is a schematic cross-sectional view for explaining a cleaning method after the separation of the laminate. An embodiment of a method for producing a semiconductor package (electronic component) can be described with reference to Figs. 9 to 11.

As shown in Fig. 9, the step of separating the laminate is a step of separating the electronic device layer 6 and the support substrate 3 by irradiating the adhesive layer 2 with light (arrow) through the support substrate 3 to alter the adhesive layer 2.

After the adhesive layer 2 is irradiated with light (arrow) to alter the adhesive layer 2, the support substrate 3 is separated from the electronic device layer 6 as shown in Fig. 10.

The irradiation conditions, irradiation method, and the like of light irradiation on the adhesive layer are as described in the section of <Third embodiment> above.

The substrate can be cleaned by spraying a cleaning agent composition onto the surface of at least one of the separated electronic device layer and support substrate, or immersing the separated electronic device layer or support substrate in a cleaning agent composition.

In addition, the surface of the processed electronic device layer or the like may be cleaned using a removal tape or the like.

For example, in Fig. 10, the adhesive layer 2 adheres to the electronic device layer 6 after the separation step, but the adhesive layer 2 can be removed by decomposing the adhesive layer 2 using a cleaning agent composition such as an acid or an alkali. By removing the adhesive layer, a processed electronic device layer (electronic component) as shown in Fig. 11 can be suitably obtained.

The constituent elements and methodological elements related to the above-described steps of the method for producing a processed electronic device layer of the present invention may be variously changed without departing from the gist of the present invention.

The method for producing a processed electronic device layer of the present invention may include steps other than the above-described steps.

In the laminate of the present invention, the electronic device layer and the support substrate are temporarily adhered by the adhesive layer in a suitably releasable manner. Therefore, for example, when the support substrate has light transmittance, the electronic device layer and the support substrate can be easily separated by irradiating the adhesive layer with light from the support substrate side of the laminate. Usually, release is performed after the electronic device layer of the laminate is processed.

### Examples

Hereinafter, the present invention will be described more specifically with reference to examples, but the present invention is not limited to the following examples. The apparatus used is as follows.

### [Apparatus]

(1) Stirrer: Rotation and revolution mixer ARE-500, manufactured by THINKY CORPORATION
(2) Viscometer: rotational viscometer TVE-22H, manufactured by Toki Sangyo Co., Ltd.
(3) Vacuum bonding apparatus: manual bonder, manufactured by SUSS MicroTec SE
(4) Laser irradiation apparatus: NC-LD300 EXC, manufactured by Optec Inc.
(5) Bonding equipment: manufactured by Ayumi Industry Co., Ltd.

### [1] Preparation of composition

### [Preparation Example 1]

In a 100 mL glass bottle, 10 g of polyacrylic acid (molecular weight: 450,000, manufactured by Sigma-Aldrich Co. LLC) and 90 g of propylene glycol monomethyl ether (manufactured by Tokyo Chemical Industry Co., Ltd.) were placed and stirred to prepare a composition (1).

### [Preparation Example 2]

In a 100 mL glass bottle, 18 g of tannic acid (manufactured by Kanto Chemical Co., Inc.), 2 g of polyacrylic acid (molecular weight: 450,000, manufactured by Sigma-Aldrich Co. LLC), and 80 g of propylene glycol monomethyl ether (manufactured by Tokyo Chemical Industry Co., Ltd.) were placed and stirred to prepare a composition (2).

### [Preparation Example 3]

In a 100 mL glass bottle, 7 g of tannic acid (manufactured by Kanto Chemical Co., Inc.), 3 g of polyacrylic acid (molecular weight: 450,000, manufactured by Sigma-Aldrich Co. LLC), and 90 g of propylene glycol monomethyl ether (manufactured by Tokyo Chemical Industry Co., Ltd.) were placed and stirred to prepare a composition (3).

### [Preparation Example 4]

In a 100 mL glass bottle, 5 g of tannic acid (manufactured by Kanto Chemical Co., Inc.), 5 g of polyacrylic acid (molecular weight: 450,000, manufactured by Sigma-Aldrich Co. LLC), and 90 g of propylene glycol monomethyl ether (manufactured by Tokyo Chemical Industry Co., Ltd.) were placed and stirred to prepare a composition (4).

### [Preparation Example 5]

In a 100 mL glass bottle, 18 g of tannic acid (manufactured by Kanto Chemical Co., Inc.), 2 g of polymethyl methacrylate (molecular weight: 133,300, manufactured by Tokyo Chemical Industry Co., Ltd.), and 80 g of propylene glycol monomethyl ether (manufactured by Tokyo Chemical Industry Co., Ltd.) were placed and stirred to prepare a composition (5).

### [Preparation Example 6]

In a 100 mL glass bottle, 14 g of tannic acid (manufactured by Kanto Chemical Co., Inc.), 6 g of polymethyl methacrylate (molecular weight: 133,300, manufactured by Tokyo Chemical Industry Co., Ltd.), and 80 g of propylene glycol monomethyl ether (manufactured by Tokyo Chemical Industry Co., Ltd.) were placed and stirred to prepare a composition (6).

### [Preparation Example 7]

In a 100 mL glass bottle, 10 g of tannic acid (manufactured by Kanto Chemical Co., Inc.), 10 g of polymethyl methacrylate (molecular weight: 133,300, manufactured by Tokyo Chemical Industry Co., Ltd.), and 80 g of propylene glycol monomethyl ether (manufactured by Tokyo Chemical Industry Co., Ltd.) were placed and stirred to prepare a composition (6).

### [Preparation Example 8]

In a 100 mL glass bottle, 4.5 g of cinnamic acid (manufactured by Tokyo Chemical Industry Co., Ltd.), 10.5 g of polyacrylic acid (molecular weight: 450,000, manufactured by Sigma-Aldrich Co. LLC), and 85 g of propylene glycol monomethyl ether (manufactured by Tokyo Chemical Industry Co., Ltd.) were placed and stirred to prepare a composition (8).

### [Preparation Example 9]

In a 100 mL glass bottle, 4.5 g of 2-(p-toluoyl)benzoic acid (manufactured by Tokyo Chemical Industry Co., Ltd.), 10.5 g of polyacrylic acid (molecular weight: 450,000, manufactured by Sigma-Aldrich Co. LLC), and 85 g of propylene glycol monomethyl ether (manufactured by Tokyo Chemical Industry Co., Ltd.) were placed and stirred to prepare a composition (9).

### [Preparation Example 10]

In a 100 mL glass bottle, 4.5 g of 2-naphthyloxyacetic acid (manufactured by Tokyo Chemical Industry Co., Ltd.), 10.5 g of polyacrylic acid (molecular weight: 450,000, manufactured by Sigma-Aldrich Co. LLC), and 85 g of propylene glycol monomethyl ether (manufactured by Tokyo Chemical Industry Co., Ltd.) were placed and stirred to prepare a composition (10).

### [Preparation Example 11]

An adhesive composition (A) used in Example 1 was prepared as follows.

In a 600 mL stirring vessel dedicated to a stirrer, 80 g of an MQ resin (manufactured by Wacker Chemie AG) containing a polysiloxane and a vinyl group as a polyorganosiloxane (a1), 2.52 g of a SiH group-containing linear polydimethylsiloxane (manufactured by Wacker Chemie AG) having a viscosity of 100 mPa·s as a polyorganosiloxane (a2), 5.89 g of a SiH group-containing linear polydimethylsiloxane (manufactured by Wacker Chemie AG) having a viscosity of 70 mPa·s as a polyorganosiloxane (a2), and 0.22 g of 1-ethynylcyclohexanol (manufactured by Wacker Chemie AG) as a polymerization inhibitor (A3) were placed and stirred with a stirrer for 5 minutes.

To the resulting mixture, 3.96 g of a mixture obtained by stirring 0.147 g of a platinum catalyst (manufactured by Wacker Chemie AG) as a platinum group metal-based catalyst (A2) and 5.81 g of a vinyl group-containing linear polydimethylsiloxane (manufactured by Wacker Chemie AG) having a viscosity of 1,000 mPa·s as a polyorganosiloxane (a1) with a stirrer for 5 minutes was added, followed by stirring with a stirrer for 5 minutes.

Finally, the resulting mixture was filtered through a nylon filter 300 mesh to obtain the adhesive composition (A). The viscosity of the adhesive measured with a viscometer was 10,000 mPa·s.

In order to check whether or not an adhesive layer formed using the adhesive composition for release by light irradiation of the present invention can be easily released by laser irradiation, a laminate described in the following Example 1 was prepared, and a laser irradiation test described in the following Example 2 was performed.

### [Example 1] Preparation of laminate

The adhesive composition (A) was applied to a 100 mm silicon wafer (thickness: 500 µm) as a device-side wafer with a spin coater to form an adhesive composition layer (A) having a thickness of 30 µm**.** A 100-mm glass wafer (EAGLE-XG, manufactured by Corning Incorporated, thickness: 500 µm) was prepared as a carrier-side wafer (support), and each of the compositions (1) to (10) was applied with a spin coater and heated on a 90°C hot plate for 90 seconds to form composition layers (1) to (10) to have a thickness of 2.5 µm. The adhesive composition layer (A) and each of the composition layers (1) to (10) were bonded to each other in a vacuum bonding apparatus so as to sandwich the adhesive composition layer (A) and each of the composition layers (1) to (10) to prepare a laminate. Thereafter, a heating treatment was performed at 200°C for 10 minutes with the device-side wafer facing downward on a hot plate to cure each composition layer to obtain laminates (1) to (10).

Laminates obtained using the composition layers (1) to (10) correspond to the laminates (1) to (10), respectively.

### [Example 2] Laser irradiation test

The obtained laminates (1) to (10) were irradiated with a laser at an output of 250 mJ/cm² from the glass wafer side using a laser irradiation apparatus, and it was checked whether the glass wafer can be released. After the laser irradiation, the glass wafer was lifted with tweezers, and a case where the glass wafer could be easily released was marked as "∘", and a case where the glass wafer could not be released was marked as "×".

Subsequently, in order to check whether or not the adhesive layer formed using the adhesive composition for release by light irradiation of the present invention exhibits strong adhesiveness to a plurality of chip substrates, a chip substrate fixing test described in Example 3 below was performed.

### [Example 3] Chip substrate fixing test

A 100-mm glass wafer (EAGLE-XG, manufactured by Corning Incorporated, thickness: 500 µm) was prepared, and each of the compositions (1) to (10) was applied with a spin coater and heated on a 90°C hot plate for 90 seconds to form composition layers (1) to (10) to have a thickness of 2.5 µm. Three 2-cm square silicon substrates (thickness: 400 µm) were placed in a composition layer, a glass wafer was placed on a stage in a bonding equipment set to 110°C, and thermocompression bonding was performed at a load of 160 kg for 1 minute.

The glass wafer after compression bonding was taken out and cooled, and then the glass wafer was made perpendicular to the ground, and a case where the fixed 2-cm square silicon substrates were fixed without being released was marked as "∘", and a case where the fixed 2-cm square silicon substrates were not fixed and dropped was marked as "×".

Test results of Example 2 and Example 3 are shown in Table 1 below.

**[Table 1]**

| Composition layer | Laser irradiation test results [Example 2] | Chip fixing test results [Example 3] |
|---|---|---|
| 1 | × | ○ |
| 2 | ○ | ○ |
| 3 | ○ | ○ |
| 4 | ○ | ○ |
| 5 | ○ | ○ |
| 6 | ○ | ○ |
| 7 | ○ | ○ |
| 8 | ○ | ○ |
| 9 | ○ | ○ |
| 10 | ○ | ○ |

From the above examples, it was found that the composition layers (2) to (10) formed using the adhesive composition for release by light irradiation defined in the present invention exhibited excellent results in both releasability after laser irradiation and fixability of a plurality of chip substrates.

Therefore, the adhesive composition for release by light irradiation defined in the present invention can form an adhesive layer capable of firmly adhering the support substrate and the semiconductor substrate or the electronic device layer at the time of processing the semiconductor substrate or the electronic device layer, and capable of easily separating the support substrate and the semiconductor substrate or the electronic device layer by light irradiation after processing the substrate.

### Reference Signs List

- 1: Semiconductor substrate
- 2: Adhesive layer
- 3: Support substrate
- 4: Semiconductor chip substrate
- 5: Sealing resin
- 6: Electronic device layer
- 7: Wiring layer

## Claims

1. An adhesive composition for release by light irradiation for forming an adhesive layer of a laminate including a semiconductor substrate or an electronic device layer, a support substrate, and the adhesive layer provided between the semiconductor substrate or the electronic device layer and the support substrate, in which the electronic device layer includes a plurality of semiconductor chip substrates and a sealing resin disposed between the semiconductor chip substrates, and the adhesive layer is used to release the semiconductor substrate or the electronic device layer and the support substrate after the adhesive layer absorbs light emitted from the support substrate side,
the adhesive composition comprising: a light-absorbing compound that contributes to facilitating release of the semiconductor substrate or the electronic device layer and the support substrate by absorbing the light; an organic resin; and an organic solvent, wherein
the light-absorbing compound is a compound having a structure selected from a group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, and a structure derived from cinnamic acid, or a polyphenol-based compound.

2. The adhesive composition according to claim 1, wherein the light-absorbing compound is a compound having a structure represented by any one of formulae (1) to (8) below: 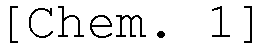 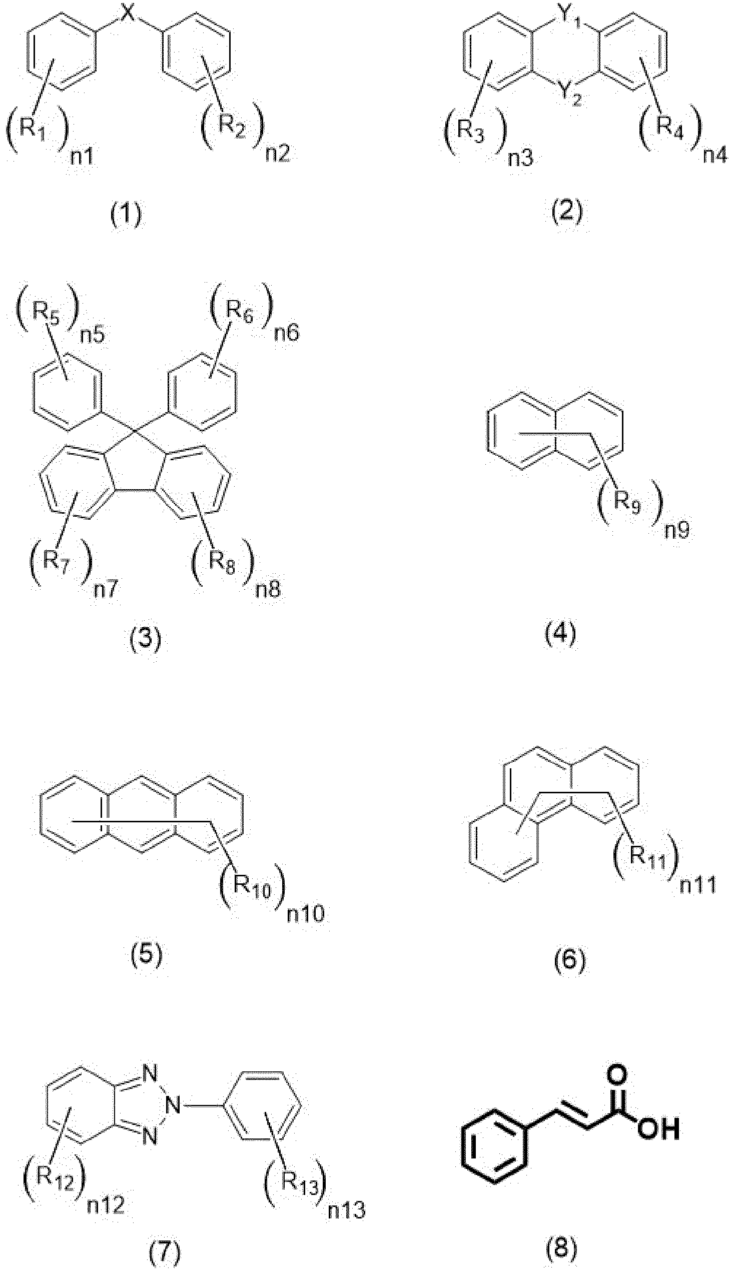
wherein R₁ to R₁₃ each independently represent a halogen atom or a monovalent group,
X represents a single bond, -O-, -CO-, -NR₃₁- (R₃₁ represents a hydrogen atom, an alkyl group which may be substituted, or an aryl group which may be substituted), - SO-, -SO₂-, or -N=N-,
Y₁ represents a single bond or -CO-, when Y₁ is a single bond, Y₂ represents -O-, -CO-, or -NR₃₂- (R₃₂ represents a hydrogen atom, an alkyl group which may be substituted, or an aryl group which may be substituted), when Y₁ is -CO-, Y₂ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,
n13 is an integer of 0 to 4
* represents a bond, and
when there are a plurality of R₁'s to R₁₃'s, each of the plurality of R₁'s to R₁₃'s may be identical or different.

3. The adhesive composition according to claim 1, wherein the polyphenol-based compound in the light-absorbing compound is a compound selected from a group consisting of a condensed tannin formed by polymerization of a compound having a flavanol skeleton, a hydrolyzable tannin formed by ester bonding between an aromatic compound of gallic acid or ellagic acid and a sugar, and a flavonoid derived from a compound having a flavanone skeleton structure.

4. The adhesive composition according to claim 3, wherein the hydrolyzable tannin is tannic acid represented by formula (9) below:

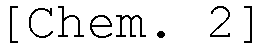

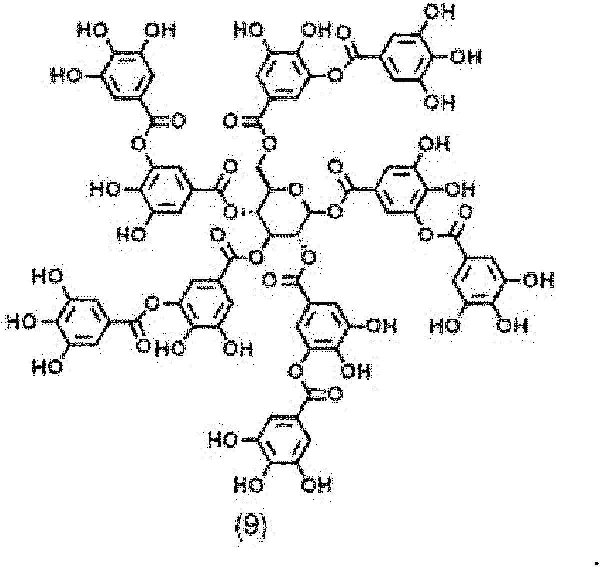

5. A laminate, comprising:
a semiconductor substrate or an electronic device layer;
a light-transmissive support substrate; and
an adhesive layer provided between the semiconductor substrate or the electronic device layer and the support substrate, wherein
the electronic device layer includes a plurality of semiconductor chip substrates and a sealing resin disposed between the semiconductor chip substrates,
the adhesive layer is used to release the semiconductor substrate or the electronic device layer and the support substrate after the adhesive layer absorbs light emitted from the support substrate side, and
the adhesive layer is formed from the adhesive composition according to any one of claims 1 to 4.

6. A method for producing a processed semiconductor substrate or electronic device layer, the method comprising:
a step 5A of processing the semiconductor substrate of the laminate according to claim 5, or a step 5B of processing the electronic device layer of the laminate according to claim 5; and
a step 6A of separating the semiconductor substrate processed in the step 5A and the support substrate from each other, or a step 6B of separating the electronic device layer processed in the step 5B and the support substrate from each other.

7. The method for producing a processed semiconductor substrate or electronic device layer according to claim 6, wherein the step 6A or the step 6B includes a step of irradiating the laminate with a laser from the support substrate side.
